# EUROPEAN PATENT APPLICATION

(11) **EP 2 352 218 A2**
(43) Date of publication of application: **03.08.2011**
(21) Application number: 09836276.7
(22) Date of filing: 19.10.2009
(51) Int. Cl.: H02J 7/14

(54) **VOLTAGE EQUALIZATION CIRCUIT FOR ELECTRIC ENERGY STORAGE DEVICE**

(30) Priority: 27.10.2008 KR 20080105387
(71) Applicant: Kim's Techknowledge Inc., Daejeon 305-434 (KR)
(72) Inventor: KIM, Seong Min, Daejeon 305-335 (KR)
(74) Representative: Molnia, David
(86) International application number: PCT/KR2009/006016
(87) International publication number: WO 2010/076955

(57) **Abstract**

The present invention is to provide a simple and inexpensive unit for voltage equalization between electric energy storage cells in electric energy storage devices in which electric energy storage cell such as a battery or a capacitor are connected in series, that is, a voltage equalization apparatus that performing the voltage equalization between the electric energy storage cells by transferring the electric energy of the electric energy storage cell having high voltage to the electric energy storage cell having low voltage using at least one voltage equalization cell as a medium.

## Description

### [Technical Field]

The present invention relates to a voltage equalization apparatus of an electrical energy storage apparatus, and more particularly, to a voltage equalization apparatus capable of rapidly performing voltage equalization between electrical energy storage cells in the electric energy storage device configured by connecting electrical storage cells in series.

### [Background Art]

Generally, an electric energy storage cell such as a battery or an ultracapacitor has only several Volts but requires several tens of volts to several hundreds of volts in most applications. As a result, several hundreds of electric energy storage cells such as a battery, an ultracapacitor are connected in series to configure an electric energy storage device.

However, in order to normally operate the electric energy storage cell, such as a battery, an ultracapacitor, charging and discharging are performed within a normal operating voltage region. When the electric energy storage cell is operated in the region out of the normal operating voltage region, for example, when the electric energy storage cell is operated in the under-voltage or over-voltage state, the lifespan of the electric energy storage cell is sharply shortened or accidents such as explosion or fire may occur.

Therefore, in order to connect the electric energy storage cells in series, each electric energy storage cell has the same characteristics. That is, a manufacturer, a model, capacity, leakage current, or the like, are the same. Even the same manufacturing date and the same lot number are required.

However, the characteristics of the electric energy storage cell such as a battery or an ultracapacitor may be changed according to temperature. Further, since the electric energy storage device in which the electric energy storage cells are connected in series has temperature deviations or aging deviations between the electric energy storage cells according to the position of the storage cell, it is very difficult to continuously maintain the voltage equalization between the electric energy storage cells by using only the electric energy storage cells.

Due to the realistic difficulty, devices for voltage equalization between the electric energy storage cells has been developed. There is a simple method of preventing over-voltage that is one of the most significant risk factors by connecting elements serving as a zener diode in each electric energy storage cell in parallel, which is only a method for preventing over-voltage, not the voltage equalization device in a strict sense. In particular, since the electric energy storage cell such as a battery or an ultracapacitor causes the aging deviations according to voltage, a need exists for a precise voltage equalization circuit in order to maintain stable characteristics for a long period of time.

As the related art, there is a method of entirely equally maintaining the voltage between batteries and reducing electric energy loss by repeating an operation that connects a capacitor to each battery or a group of batteries through a switch in parallel and cuts the switch to connect to adjacent batteries in parallel so as to transfer the electric energy of a battery having high voltage to a battery having low voltage. However, the method has a disadvantage in causing the price increase due to a large number of parts. In particular, when the electric energy storage device is configured of a battery having small capacity, the price of the voltage equalization circuit has a disadvantage in occupying a large portion in the whole price.

As another related art, there is a method of entirely equalizing voltage and reducing electric energy loss by repeating an operation that connects voltage calibration batteries to each battery, which is connected in series, in parallel for a defined time and again connects them to other batteries in parallel in order to transfer the electric energy from the battery having high voltage to the battery having low voltage among the batteries connected in series. However, the method has a relatively simple structure, but degrades a rate forming the voltage equalization due to the transfer of the electric energy between the batteries.

As another related art, there is a method of performing voltage equalization through the transfer of electric energy between batteries connected in series by repeating an operation that connects the energy storage circuits including the energy storage unit such as the capacitor to the batteries, which are connected in series, in parallel for a defined time and again connects the energy storage units configuring the energy storage circuit. However, the method may structurally increase the voltage equalization rate and has a complicated structure, thereby greatly increasing the manufacturing costs.

### [Disclosure]

### [Technical Problem]

The present invention proposes to solve the above-mentioned problems. The object of the present invention is to provide a voltage equalization circuit capable of rapidly and effectively performing voltage equalization on a unit cell of an electric energy storage device.

### [Technical Solution]

An exemplary embodiment of the present invention provides a voltage equalization circuit, including: an electric energy storage cell serial string in which a plurality of electric energy storage cells are connected in series; at least one voltage equalization cell string that includes at least one voltage equalization cell; a plurality of first switching units that connects the electric energy storage cell with the voltage equalization cell in parallel; at least one second switching unit that connects the electric energy storage cell serial string with the voltage equalization cell string in parallel; and a controller that controls the first switching unit and the second switching unit and performs a control so that the first switching unit and the second switching unit are not simultaneously in an ON state.

### [Advantageous Effects]

As set forth above, the exemplary embodiments of the present invention repeats the operation that connects the voltage equalization cell to the electric energy storage cell in parallel by the switching unit for the defined time by the controller and again connects the voltage equalization cell string to the serial string in parallel for the defined time by the controller in order to transfer the electric energy between the electric energy storage cells, thereby equalizing the voltage between the electric energy storage cells and reducing the electric energy loss and increasing the voltage equalization rate during the process of the voltage equalization operation, as compared with the related art.

Further, the exemplary embodiments of the present invention have the simple structure, thereby reducing the manufacturing costs.

### [Description of Drawings]

FIG. 1 is a circuit diagram showing a voltage equalization circuit of an electric energy storage device according to a first exemplary embodiment of the present invention.

FIG. 2 is a circuit diagram showing the voltage equalization circuit using a plurality of voltage equalization cells according to an exemplary embodiment of the present invention.

FIG. 3 is a circuit diagram of a voltage equalization circuit divided into a module according to the exemplary embodiment of the present invention when the electric energy storage device is divided into two modules.

FIG. 4 is a circuit diagram of the voltage equalization circuit according to the exemplary embodiment of the present invention using a voltage buffer cell.

FIG. 5 is a circuit diagram of the voltage equalization circuit increasing an electric energy transfer rate according to the exemplary embodiment of the present invention.

FIG. 6 is a circuit diagram of a circuit setting a current direction in FIG. 5.

FIG. 7 is a circuit diagram of the voltage equalization circuit that may prevent a delay during the voltage equalization process.

FIG. 8 is a circuit diagram of the voltage equalization circuit that may increase the voltage equalization rate by differentiating the voltage equalization for each unit cell according to the exemplary embodiment of the present invention.

FIG. 9 is a graph showing a potential difference during the charging/discharging process of unit cells having different capacities that are connected in series.

FIG. 10 is a circuit diagram of the voltage equalization circuit having an over-voltage preventing function according to the exemplary embodiment of the present invention.

### [Best Mode]

Hereinafter, exemplary embodiments of the present invention will be described in detail with reference to the accompanying drawings.

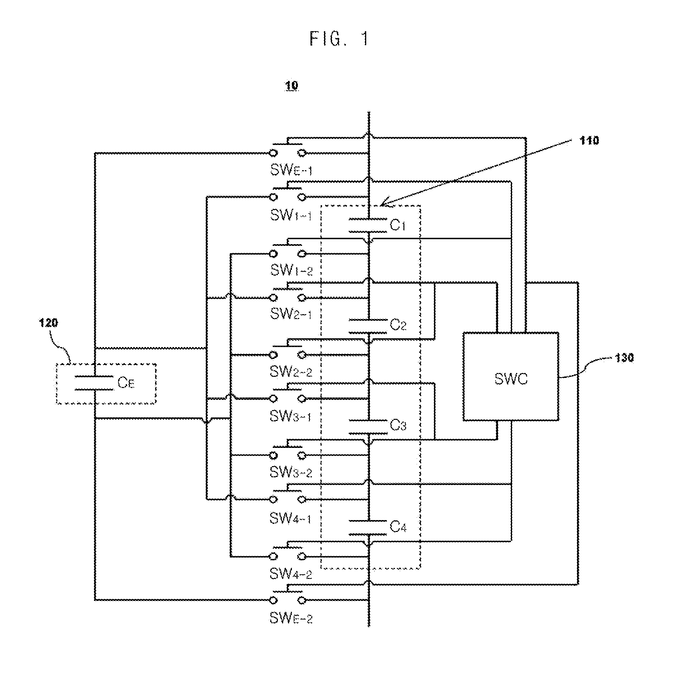

FIG. 1 is a circuit diagram showing a voltage equalization circuit of an electric energy storage device according to a first exemplary embodiment of the present invention.

As shown in FIG. 1, a voltage equalization circuit 10 according to a first exemplary embodiment of the present invention is configured to include an electric energy storage cell serial string (hereinafter, referred to 'unit cell serial string') CS 110 in which four electric energy storage cells (hereinafter, referred to as 'unit cell') C₁, C₂, C₃, and C₄ are connected in series, a single voltage equalization cell C_{E}, 120, switches SW₁₋₁, SW₁₋₂, SW₂₋₁, SW₂₋₂, SW₃₋₁, SW₃₋₂, SW₄₋₁, and SW₄₋₂ that connect the voltage equalization cell 120 with the unit cells C₁, C₂, C₃, and C₄ in parallel, switches SW_{E-1} and SW_{E-2} that connect the serial string 110 with the voltage equalization cell 120 in parallel, and a controller SWC 130 that controls the switches.

Hereinafter, an operation of the voltage equalization circuit 10 shown in FIG. 1 will be described in detail.

In order to connect the voltage equalization cell 120 with the first unit cell C₁ in parallel for a predetermined time, the switches SW₁₋₁ and SW₁₋₂ connected with the first unit cell maintain an ON state according to a controller 130. Thereafter, the switches SW₁₋₁ and SW₁₋₂ are in an OFF state by the controller 130 and the switches SW_{E-1} and SW_{E-2} are turned-on by the controller 130 so that the voltage equalization cell 120 is connected to the serial string 110 in parallel for a predetermined time. After the switches SW_{E-1} and SW_{E-2} are again turned-off by the controller 130, the switches SW₂₋₁ and SW₂₋₂ are turned-on by the controller 130 so that the voltage equalization cell 120 is connected with the second unit cell C₂ in parallel for a predetermined time. After the switches SW₂₋₁ and SW₂₋₂ are again turned-off by the controller 130, the switches SW_{E-1} and SW_{E-2} are turned-on by the controller 130 so that the voltage equalization cell 120 is connected to the serial string 110 in parallel for a predetermined time. Thereafter, the operation of sequentially connecting the above-mentioned unit cell with the serial string in parallel is sequentially repeated even for the number 3 unit cell and the number 4 unit cell.

The electric energy of the serial string 110 may transferred to each unit cell C₁, C₂, C₃, and C₄ of the serial string 110 using the voltage equalization cell 120, by connecting the sequentially repeated voltage equalization cell 120 with each unit cell or the voltage equalization cell 120 with the serial string in parallel. In this case, when the voltage equalization of the serial string 110 is not made, the lower the unit cell, the higher the voltage difference with the serial string 110 becomes. As a result, the higher electric energy is transferred to the unit cell having low voltage, such that the voltage equalization is made.

For example, the assumption that an electric double layer capacitor unit cell having a capacity of 100F is used as the unit cells C₁, C₂, C₃, and C₄ of the serial string shown in FIG.1, an aluminum electrolytic capacitor having a capacity of 0.1 F is used as the voltage equalization cell, the charging voltage of the serial string 110 is 10V, and each charging voltage of the electric double layer capacitor unit cell forming the serial string is 2.4V, 2.4V, 2.8V, or 2.4V will be described below.

After the parallel connection between the serial string 110 and the voltage equalization cell 120 is released, the voltage of the voltage equalization cell 120 and the unit cell becomes 2.4075V when the voltage equalization cell 120 and the unit cell having voltage of 2.4V are connected in parallel, but the voltage of the voltage equalization cell 120 and the unit cell becomes 2.80719V when the voltage equalization cell 120 and the unit cell having voltage of 2.8V are connected in parallel. That is, in the case in which the voltage equalization cell 120 is connected with the unit cell having voltage of 2.4V in parallel, the increase amount in voltage is 0.0004V larger than the case in which the voltage equalization cell 120 is connected with the unit cell having voltage of 2.8V in parallel. In this case, when the capacity of the voltage equalization cell 120 is increased, the increase amount in voltage is increased.

As can be appreciated from the above-mentioned voltage equalization process, when the voltages of each unit cell C₁, C₂, C₃, and C₄ of the serial string are entirely increased by the voltage equalization cell 120 but are discharged by connecting the voltage equalization cell 120 with the single unit cell in parallel and then, the voltage equalization cell 120 is again connected with the serial string 110 in parallel, the process of charging the voltage equalization cell 120 by the electric energy of the serial string 110 is performed and thus, the serial string 100 is discharged. During the process of discharging the serial string 110, the voltage drop amount of the unit cells configuring the serial string 110 is the same regardless of the voltage of the unit cell.

In other words, during the process in which the voltage equalization cell 120 repeats the charging and the discharging between the serial string 110 and the unit cells C₁, C₂, C₃, and C₄ of the serial string, the unit cell having low voltage has a larger increase amount of voltage during the process in which the voltage equalization cell 120 is connected with the unit cell having low voltage in parallel , while each unit cell forming the serial string 110 drops to the same magnitude in voltage regardless of the voltage of the unit cell during the process in which the voltage equalization cell is charged by connecting the voltage equalization cell 120 with the serial string 110 in parallel. Therefore, due to the repeated process, the unit cell in which the voltage of the serial string 110 is low is repeatedly subjected to the same voltage drop process as the voltage increase process higher than the unit cell having high voltage, such that each unit cell of the serial string 110 may achieve the voltage equalization.

In the case of the related art, there is a problem in that the voltage equalization rate is slow due to the electric energy transferred between the unit cells at a one-time operation using a voltage calibration capacitor for voltage equalization as a medium. On the other hand, the exemplary embodiment of the present invention uses the voltage equalization cell to transfer the electric energy between the unit cell and the serial string at the one-time operation, such that the voltage equalization rate may be increased.

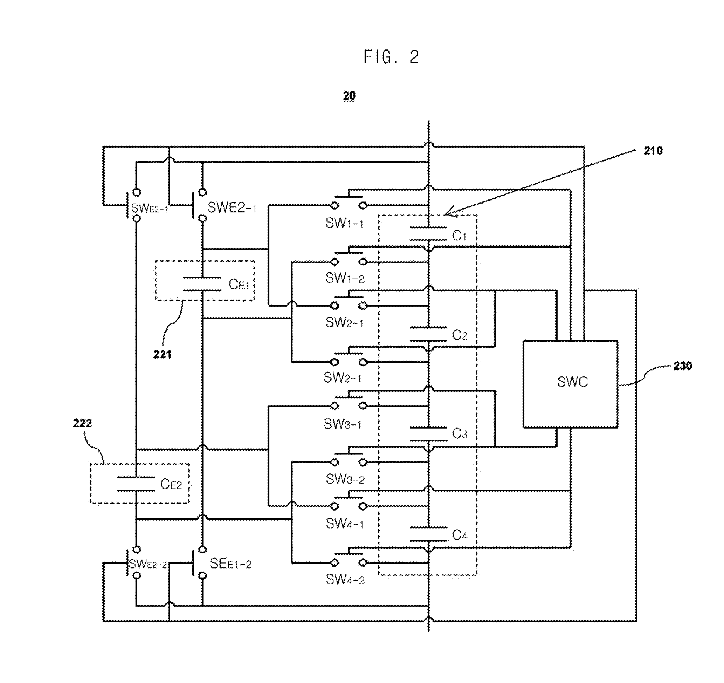

In addition, in order for the exemplary embodiment of the present invention to increase the voltage equalization rate, a plurality of voltage equalization cells may be used. Hereinafter, the exemplary embodiment including the plurality of voltage equalization cells will be described in detail with reference to FIG. 2.

FIG. 2 is a circuit diagram showing the voltage equalization circuit using the plurality of voltage equalization circuits according to an exemplary embodiment of the present invention.

As shown in FIG. 2, a voltage equalization circuit 20 according to the exemplary embodiment of the present invention is configured to include a serial string CS 210 in which four electric double layer capacitor unit cells C₁, C₂, C₃, and C₄ are connected in series, two voltage equalization cells C_{E1} 221 and C_{E2} 222 that are connected to the serial strings, respectively, in parallel, switches SW₁₋₁, SW₁₋₂, SW₂₋₁, SW₂₋₂, SW₃₋₁, SW₃₋₂, SW₄₋₁, and SW₄₋₂ that connect the voltage equalization cell 221 and 222 with each unit cell C₁, C₂, C₃, and C₄ of the serial string in parallel, switches SW_{E1-1}, SW_{E1-2}, SW_{E2-1}, and SW_{E2-2} that connect the serial string 210 with the voltage equalization cells 221 and 222 in parallel, and the controller SWC 130 that controls the switches.

In this case, the first voltage equalization cell C_{E1} 221 is connected with the first unit cell C₁ or the second unit cell C₂ of the serial string in parallel and the second voltage equalization cell C_{E2}222 may be connected with the number 3 unit cell C₃ or the number 4 unit cell C₄of the serial string.

Hereinafter, an operation of the voltage equalization circuit 20 shown in FIG. 2 will be described in detail.

The controller 230 performs a control so that the switches SW_{E1-1}, SW_{E1-2}, SW_{E2-1}, and SW_{E2-2} connecting the C_{E1} 221 and the C_{E2} 222 with the serial string 210 in parallel are turned-off and then controls each switch SW₁₋₁, SW₁₋₂, SW₂₋₁, SW₂₋₂, SW₃₋₁, SW₃₋₂, SW₄₋₁, or SW₄₋₂ so that first voltage equation cell C_{E1} 221 is connected with the first unit cell C₁ or the second unit cell C₂ in parallel and the second voltage equalization cell C_{E2} 222 is connected with the number 3 unit cell C₃ or the number 4 unit cell C₄ in parallel for a predetermined time. Thereafter, the controller 230 performs a control so that the switches SW₁₋₁, SW₁₋₂, SW₂₋₁, SW₂₋₂, SW₃₋₁, SW_{3-2,} SW₄₋₁, and SW₄₋₂ are in an OFF state in order to release the parallel connection of the voltage equation cells 221 and 222 with the unit cells and then, performs a control so that the switches SW_{E1-1} to SW_{E2-2} are in an ON state in order to connect the voltage equalization cells 221 and 222 with the serial string 210 in parallel for a predetermined time.

The voltage equalization may be made between the unit cells C₁, C₂, C₃, and C₄ within the serial string by repeating the process in which the voltage equalization cells 221 and 222 are connected with the unit cells C₁, C₂, C₃, and C₄ in parallel and the voltage equalization cells 221 and 222 are then connected with the serial string 210 in parallel for a predetermined time.

In this case, the parallel connection between voltage equalization cells 221 and 222 and the unit cells C₁, C₂, C₃, and C₄ may be sequentially made. Alternatively, when the voltage for the unit cells C₁, C₂, C₃, and C₄ may be detected, the parallel connection for the specific unit cell may be intensively performed according to the result of the voltage detection of each unit cell C₁, C₂, C₃, and C₄.

Although the exemplary embodiment is described by synchronizing the switches SW_{E1-1} and SW_{E1-2} connected with the first voltage equalization cell and the switches SW_{E2-1} and SW_{E2-2} connected with the second voltage equalization cell in order to help the understanding of the operation of the voltage equalization, these switches may be independently operated from each other without synchronizing the switching operation of the first voltage equalization cell and the switching operation of the second voltage equalization cell.

Further, the above-mentioned exemplary embodiment is practiced using two voltage equalization cells 221 and 222, but is provided only for convenience of explanation and does not limit the present invention. Therefore, the exemplary embodiment of the present invention may be configured by increasing the number of voltage equalization cells. In this case, since the frequency of the parallel connection per hour between the unit cell and the voltage equalization cell may be increased and thus, the voltage equalization rate may be increased. As described above, increasing the number of voltage equalization cells is an effective method of preventing the voltage equalization rate from reducing in even when the number of serially connected unit cells of the series string is increased.

When the electric energy storage device is configured by making the electric double layer capacitor or the secondary battery into the unit cell and connecting them in series, as the number of unit cells connected in series is increased, the weight and volume of the electric energy storage device is increased. Therefore, when the number of unit cells connected in series is increased, the electric energy storage device may be divided into several modules. As described above, even when the electric energy storage device is configured by again connecting several modules in series, it is efficient to use the plurality of voltage equalization cells as described above.

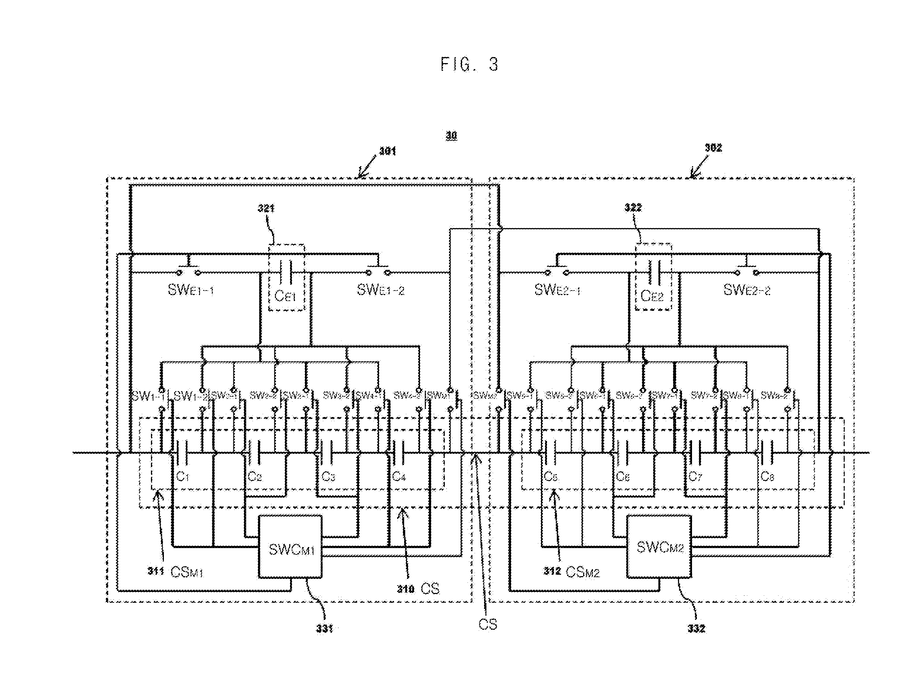

Hereinafter, the exemplary embodiment of the voltage equalization circuit for the electric energy storage device configured by being divided into the plurality of modules will be described in detail with reference to FIG. 3.

FIG. 3 is a circuit diagram of the voltage equalization circuit divided into the module according to the exemplary embodiment of the present invention when the electric energy storage device is divided into two modules.

As shown in FIG. 3, the entire serial string CS 310 is configured by connecting 8 electric double layer capacitor unit cells C₁ to C₈ in series.

A first module M₁ 301 is configured to include a first serial string CS_{M1} 311 in which four electric double layer capacitor unit cells C₁, C₂, C₃, and C₄ are connected in series, a first voltage equalization cell C_{E1} 321 connected with the entire serial string CS 310 in parallel, switches SW_{E1-1} and SW_{E1-2} that turn-on/off the parallel connection between the entire serial string CS 310 with the first voltage equalization cell C_{E1} 321, switches SW₁₋₁ to SW₄₋₂ that turn-on/off the parallel connection between the first voltage equalization cell C_{E1} 321 with the unit cells C₁, C₂, C₃, and C₄ of the first serial string CS_{M1} 311, and a first module switch controller SWC_{M1} 331 and a first module backup switch SW_{M1} that control the switches included in the first module M₁ 301.

A second module M₂ 302 is configured to include a second serial string CS_{M2} 312 in which four electric double layer capacitor unit cells C₅, C₆, C₇, and C₈ are connected in series, a second voltage equalization cell C_{E2} 322 connected with the entire serial string CS 310 in parallel, switches SW_{E2-1} and SW_{E2-2} that turn-on/off the parallel connection between the entire serial string CS 310 with the second voltage equalization cell C_{E2} 322, switches SW₅₋₁ to SW₈₋₂ that turn-on/off the parallel connection between the second voltage equalization cell C_{E2} 321 with the unit cells C₅, C₆, C₇, and C₈ of the second serial string CS_{M2} 312, and a second module switch controller SWC_{M2} 332 and a second module backup switch SW_{M2} that control the switches included in the second module M₂ 302.

The electric energy storage device is configured by connecting the first module M₁ 301 and the second module M₂ 302 in series and the entire serial string CS is configured by connecting the first serial string CS_{M1} 311 with the second serial string CS_{M2} 312 in series.

The operation of the voltage equalization circuit 30 shown in FIG. 3 is operated as a principle equivalent to the operation of the above-mentioned voltage equalization circuit 20 with reference to FIG. 2, but the voltage equalization circuit 20 of FIG. 2 operates all the switches by using a single controller, while the voltage equalization circuit 30 of FIG. 3 is a difference in having the switch controller SWC_{M1} 331 and SWC_{M2} 332 independent from each module. Further, the fact that the voltage equalization circuit 30 shown in FIG. 3 may perform the switching operation independently from each voltage equalization cell without synchronizing the switching operation of all the switches is beforehand described.

In addition, as described with reference to FIG. 3, the exemplary embodiments may be configured to be used by connecting synchronizing signal lines in order to share the synchronization signal between each module so that the voltage equalization circuit 30 may be operated by synchronizing the switches SW_{E1-1} to SW_{E2-2} used in all the modules.

The first module backup switch SW_{M1} and the second module backup switch SW_{M2} cause the problem in the parallel connection between the voltage equalization cells 321 and 322 and the entire serial string 310 of each module, such that they are turned-on when the normal voltage equalization operation is not made, thereby performing the voltage equalization for the serial strings CS_{M1} 311 and CS_{M2} 312 of each module. In this case, when an alarm signal is generated, it is more effective. Therefore, the first module backup switch SW_{M1} and the second module backup switch SW_{M2} are in an OFF state while the voltage equalization is normally performed.

As described above, even though the serial number of serial strings is increased in the electric energy storage device, each module is configured by dividing the serial string into several modules and the voltage equalization may be easily performed by using the above-mentioned voltage equalization circuit 30 for each module with reference to FIG. 3.

In the above-mentioned voltage equalization circuit, the voltage equalization operation operating by being directly connecting the voltage equalization cell with the serial string is described. However, when the serial number of serial strings connected with the voltage equalization cell in parallel is increased, the difference in voltage between the unit cell of the serial string and the serial string may be increased and thus, the instantaneous large current may repeatedly flow in the voltage equalization cell alternately connected between the unit cell and the serial string in parallel and the switch due to the large voltage difference. The large current may generate heat to cause the temperature increase, the lifespan of the device may be shortened, the price increase of the switch may be caused, and the energy efficiency of the voltage equalization circuit may be reduced and therefore, the voltage equalization circuit configured by connecting the voltage equalization cell for preventing the large current in series will be described below.

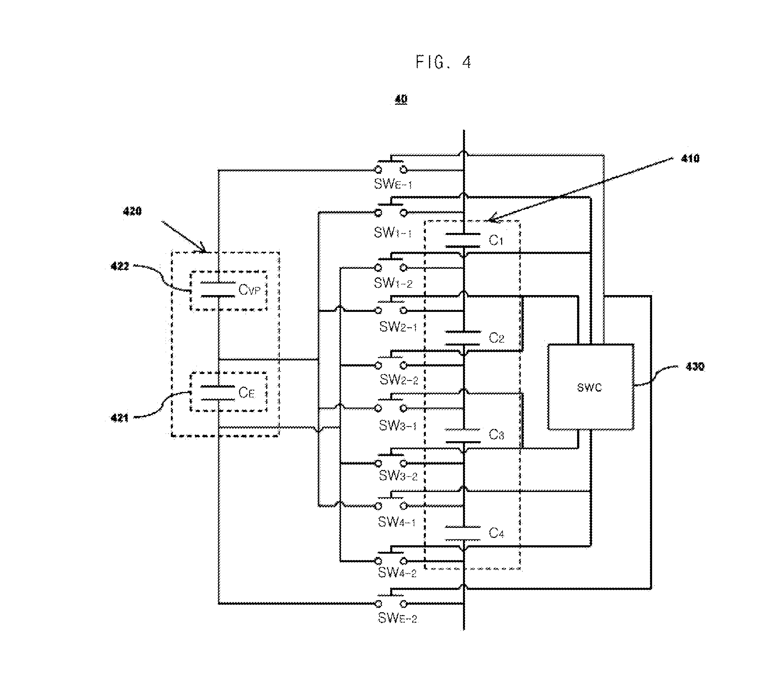

FIG. 4 is a circuit diagram of the voltage equalization circuit using a voltage buffer cell serially connected with the voltage equalization cell according to the exemplary embodiment of the present invention.

As shown in FIG. 4, a voltage equalization circuit 40 is configured to include a unit cell serial string CS 410 in which four electric double layer capacitor unit cells C₁, C₂, C₃, and C₄ are connected in series, a voltage equalization cell C_{E} 421, a voltage buffer cell C_{VP} 422, a voltage equalization cell serial string CS_{E} 420 configured by connecting the voltage equalization cell 421 with the voltage buffer cell 422 in series, switches SW₁₋₁ to SW₄₋₂ that turn-on/off the parallel connection between the voltage equalization cell CE 421 and the unit cells C₁, C₂, C₃, and C₄ of the serial string, switches SW_{E-1} andSW_{E-2} that turn-on/off the parallel connection between the serial string 410 and the voltage equalization cell string 420, and a controller SWC 430 for controlling the switches SW₁₋₁ to SW₄₋₂, and the switchesSW_{E-1} and SW_{E-2}.

The voltage equalization circuit 40 shown in FIG. 4 is connected the voltage equalization cell C_{E} of the above-mentioned voltage equalization circuit 10 in series with reference to FIG. 1, further including the voltage buffer cell C_{VP}. That is, the basic operation of the voltage equalization circuit 40 shown in FIG. 4 is the same as the operation of the voltage equalization circuit 10 shown in FIG. 1.

Hereinafter, the operation of the voltage equalization circuit 40 will be described in detail with reference to FIG. 4.

The controller SWC 430 controls the switches SW₁₋₁ to SW₄₋₂ so that the switches SW₁₋₁ to SW₄₋₂ are again in an OFF state after the voltage equalization cell C_{E} 421 is connected to the unit cell in parallel according to the defined order for the predetermined time. Thereafter, the controller SWC 430 controls the switches SW_{E-1} and SW_{E-2} to connect the voltage equalization cell serial string CS_{E} 420 with the unit cell serial string 410 in parallel. As described above, when the voltage equalization cell C_{E} 421 is connected to the unit cell in parallel, the voltage of the voltage equalization serial string CS_{E} 420 is changed by the voltage difference between the voltage of the voltage equalization cell C_{E} 421 and the voltage of the unit cell before being connected in parallel. In this case, the voltage difference corresponds to the deviations in the voltage distribution of each unit cell C₁, C₂, C₃, and C₄ configuring the serial string CS 410. Therefore, when the parallel connection switches SW₁₋₁ to SW₄₋₂ between the voltage equalization cell C_{E} 421 and the unit cell are turned-off by the controller SWC 430 and then, the parallel connection switches SW_{E-1} and SW_{E-2} between the voltage equalization cell serial string CS_{E} 420 and the unit cell serial string CS 410 are in an ON state, the voltage difference between two serial strings is not large, such that current flowing may be greatly reduced during the process of connecting two serial strings 410 and 420 in parallel. When the serial string CS 410 achieves the voltage equalization, there is no change in voltage even though the voltage equalization cell C_{E} 421 is connected with the unit cell in parallel according to the defined order, such that the voltage of the voltage equalization cell serial string CS_{E} 420 is not also changed. Therefore, the voltages of the voltage equalization cell serial string CS_{E} 420 and the unit cell serial string CS 410 are the same and therefore, current does not flow even though two serial strings 410 and 420 are connected in parallel. The voltage buffer cell C_{VP} 422 is maintained by the difference between the difference of the serial string CS 410 and the voltage of the unit cell during the voltage equalization process.

In the voltage equalization circuit 40, the capacity ratio of the voltage equalization cell C_{E} 421 and the voltage buffer cell C_{VP} 422 of the voltage equalization cell serial string CS_{E} 420 may be variously set, but the capacity of the voltage equalization cell C_{E} 421 may be set to be larger than the capacity of the voltage buffer cell C_{VP} 422.

For example, in the voltage equalization circuit 40 of FIG. 4, describing the case in which the electric double layer capacitor that is a capacitance of 100F and a rated voltage of the serial string CS 410 of 10V is used as each unit cell C₁, C₂, C₃, and C₄, the aluminum electrolytic capacitor that is a capacitance of 2200 µF and a rated voltage of 6.3V is used as the voltage equalization cell C_{E} 421, and the aluminum electrolytic capacitor that is a capacitance of 680 µF and a rated voltage of 16V is used as the voltage buffer cell C_{VP} 422, when the voltage equalization of the serial string CS 410 is performed, the voltage of the unit cells C₁, C₂, C₃, and C₄ becomes 2.5V, the voltage of the voltage equalization cell C_{E} 421 becomes 2.5V, like the voltage of the unit cells C₁, C₂, C₃, and C₄, and the voltage of the voltage buffer cell C_{VP} 422 becomes 7.5V.

Generally, when the volume is constant in the aluminum electrolytic capacitor and the tantalum electrolytic capacitor, the capacitance is small when the rated voltage is increased. Therefore, when the voltage buffer cell C_{VP} 422 is set to be same as the capacity of the voltage equalization cell C_{E} 421, the volume and prices of the voltage buffer cell C_{VP} 422 are increased, such that the voltage buffer cell C_{VP} 422 may be set to have the smaller capacitance than the voltage equalization cell C_{E} 421.

In configuring the voltage equalization cell serial string CS_{E} 420 by connecting the cells having the large difference in capacity in series, reverse voltage may be applied to the cell having small capacitance. In order to prevent the reverse voltage, even when the reverse voltage is applied to the cell by connecting a diode or the elements serving as the diode to the cell having small capacitance, the exemplary embodiment may be configured to bypass current.

In addition, although the above-mentioned description illustrates when a single voltage buffer cell C_{VP} 422 is used in the voltage equalization cell serial string CS_{E} 420, the plurality of voltage buffer cells may be connected in series.

In addition, the voltage equalization cell C_{E} 421 and the voltage buffer cell C_{VP} 422 may be used using different types of cells. For example, the aluminum electrolytic capacitor may be used as the voltage buffer cell C_{VP} 422 and the electric double layer capacitor or the tantalum electrolytic capacitor may be used as the voltage equalization cell C_{E} 421.

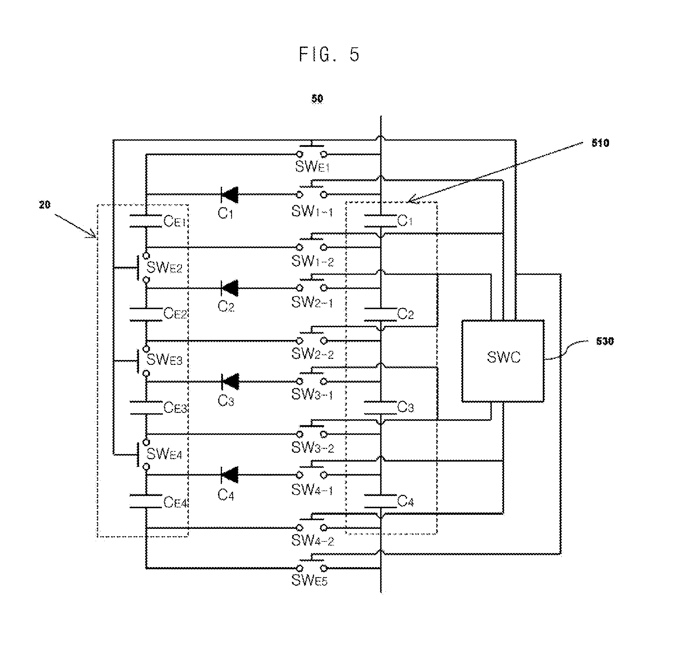

Meanwhile, as the capacity of the unit cell of the serial string CS is increased, there is a need to increase the electric energy transfer rate of the voltage equalization circuit. Therefore, the voltage equalization circuit capable of increasing the electric energy transfer rate will be described below with reference to FIG. 5.

FIG. 5 shows a circuit diagram of the voltage equalization circuit increasing an electric energy transfer rate according to the exemplary embodiment of the present invention.

As shown in FIG. 5, a voltage equalization circuit 50 is configured to include a unit cell serial string CS 510 in which four electric double layer capacitor unit cells C₁, C₂, C₃, and C₄ are connected in series, voltage equalization cells C_{E1}, C_{E2}, C_{E3}, and C_{E4} having the same capacitance corresponding to each unit cell C₁, C₂, C₃, and C₄ of the unit cell serial string, a voltage equalization cell serial string CS_{E} 520 configured by connecting the voltage equalization cells in series, switches SW₁₋₁ to SW₄₋₂ that turn-on/off the parallel connection between each voltage equalization cell C_{E1}, C_{E2},C_{E3}, and C_{E4} and each unit cell C₁, C₂, C₃, and C₄, diodes D₁, D₂, D₃, and D₄ that are connected with the switches SW₁₋₁,SW₂₋₁,SW₃₋₁, and SW₄₋₁ between the voltage equalization cells C_{E1},C_{E2},C_{E3}, and C_{E4} and the unit cells C₁, C₂, C₃, and C₄ in series, switches SW_{E1} to SW_{E5} that turn-on/off the parallel connection between the unit cell serial string CS and the voltage equalization cell serial string CS_{E}, and a controller SWC 530 controlling the switches SW₁₋₁ to SW₄₋₂ and the switches SW_{E1} to SW_{E5}.

The diodes D₁, D₂, D₃, and D₄ serve to provide the flowing of current in the direction of the voltage equalization cell from the unit cell but to prevent the flowing of current in the reverse direction. That is, the unit cell performs the discharge to the voltage equalization cell but is not charged by the voltage equalization cell. That is, the diodes serve as a current direction setting unit.

Hereinafter, the operation of the voltage equalization circuit 50 will be described in detail with reference to FIG. 5.

The voltage equalization cells C_{E1}, C_{E2}, C_{E3}, and C_{E4} of the voltage equalization cell serial string 520 are connected to each other in series by turning-on the switches SW_{E1} to SW_{E5} by the controller 530 for the predetermined time. Further, the voltage equalization cell serial string 520 is connected with the unit cell serial string 510 in parallel. Thereafter, the serial connection between the voltage equalization cells C_{E1}, C_{E2}, C_{E3}, and C_{E4} within the voltage equalization cell serial string 520 and the parallel connection of the voltage equalization cell serial string 520 and the unit cell serial string 510 are released, by turning-off the switches SW_{E1} to SW_{E5} by the controller 530. Each of the voltage equalization cells C_{E1}, C_{E2}, C_{E3}, and C_{E4} is again connected to the unit cells C₁, C₂, C₃, and C₄ corresponding thereto in parallel by turning-on the switches SW₁₋₁ to SW₄₋₂ by the controller 530 for the predetermined time. When the voltage of the unit cells C₁, C₂, C₃, and C₄ are higher than the voltage equalization cells C_{E1}, C_{E2}, C_{E3}, and C_{E4} by the diodes D₁, D₂, D₃, and D₄ during the parallel connection, current flows, such that the discharge to the voltage equalization cell is performed, but when the voltage of the unit cells C₁, C₂, C₃, and C₄ is lower than the voltage of the voltage equalization cells C_{E1}, C_{E2}, C_{E3}, and C_{E4}, current does not flow. Thereafter, the parallel connection of the voltage equalization cells C_{E1}, C_{E2}, C_{E3}, and C_{E4} with the corresponding unit cells C₁, C₂, C₃, and C₄ is released by turning-off the switches SW₁₋₁ to SW₄₋₂ by the controller 530 and then, the switches SW_{E1} to SW_{E5} are again turned-on by the controller 530 for the predetermined time, such that the voltage equalization cells C_{E1}, C_{E2}, C_{E3}, and C_{E4} of the voltage equalization cell serial string 520 are connected in series and the voltage equalization cell serial string 520 is connected with the unit cell serial string 510 in parallel. When the voltage equalization of the unit cell serial string 510 is not performed during this process, the unit cell having high voltage among the unit cells is discharged to the corresponding voltage equalization cell during the parallel connection with the voltage equalization cell. Therefore, the voltage equalization of the unit cell serial string 510 is not performed, since the voltage of the voltage equalization cell serial string 520 rises and the voltage of the unit cell serial string 510 drops when the each unit cell C₁, C₂, C₃, and C₄ corresponding to the voltage equalization cells C_{E1}, C_{E2}, C_{E3}, and C_{E4} are connected in parallel, such that current flows from the voltage equalization cell serial string 520 to the unit cell serial string 510. The voltage increase amount of the unit cells C₁, C₂, C₃, and C₄ configuring the unit cell serial string 510 during this process is the same regardless of the voltage. Therefore, the electric energy of the unit cell having the high voltage uniformly is distributed to the unit cells C₁, C₂, C₃, and C₄ of the unit cell serial string 510. The voltage equalization of the unit cell serial string 510 is performed by the repeated operation.

The diodes D₁, D₂, D₃, and D₄ in the above-mentioned voltage equalization circuit 50 is installed to provide the flowing of current only in the direction of the voltage equalization cells C_{E1}, C_{E2}, C_{E3}, and C_{E4} from the unit cells C₁, C₂, C₃, and C₄, but may reversely change the direction of the diode D₁, D₂, D₃, and D₄. In this case, when the direction of the diodes D₁, D₂, D₃, and D₄ is reversely changed, current may flow in the direction of the corresponding unit cell in each voltage equalization cell, such that current flows in the unit cell in the voltage equalization cell when the voltage of the voltage equalization cell is higher than the voltage of the corresponding unit cell. Therefore, when the voltage equalization of the unit cell serial string 510 is not performed, the voltage of each unit cell is lower than the voltage of the corresponding voltage equalization cell while the parallel connection with the unit cells C₁, C₂, C₃, and C₄ corresponding to each of the voltage equalization cells C_{E1}, C_{E2}, C_{E3}, and C_{E4} is performed, the unit cell is charged by the voltage equalization cell and the voltage of the voltage equalization cell serial string 520 is lower and the voltage of the unit cell serial string 510 rises by the operation, such that the unit cell serial string 510 charges the voltage equalization serial string 520. Each unit cell C₁, C₂, C₃, and C₄ configuring the unit cell serial string 510 during this charging process is discharged by the same amount regardless of the voltage. Therefore, the voltage equalization is performed by transferring the electric energy of the unit cell serial string 510 from the unit cell serial string 510 to the unit cell having low voltage using the voltage equalization cells C_{E1}, C_{E2}, C_{E3}, and C_{E4} as a medium.

In the voltage equalization circuit of FIG. 5, in order to set the direction of flowing current between the voltage equalization cells C_{E1}, C_{E2}, C_{E3}, and C_{E4} and the unit cells C₁, C₂, C₃, and C₄, the diodes D₁, D₂, D₃, and D₄ are connected with the switch in series, but other current direction setting unit may be used in order to perform the role.

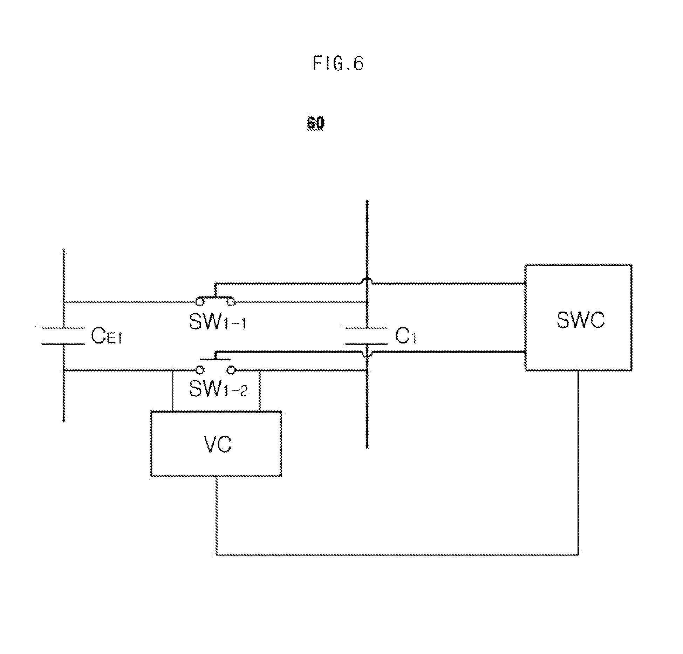

FIG. 6 shows a circuit diagram of a circuit setting the current direction according to the exemplary embodiment of the present invention.

FIG. 6 shows a current direction control circuit 60 that serves as the diode D₁ connected to the parallel connection switches SW₁₋₁ and SW₁₋₂ between the first voltage equalization cell C_{E1} and the first unit cell C₁ of FIG. 5 in series.

The current direction control circuit 60 is configured to include the unit cell C₁ in which the electric energy is stored, the voltage equation cell C_{E1}, the switches SW₁₋₁ and SW₁₋₂ connecting the unit cell C₁ and the voltage equation cell C_{E1} in parallel, a voltage comparator VC measuring the potential difference between the unit cell C₁ and the voltage equalization cell C_{E1}, and the controller SWC controlling the switches SW₁₋₁ and SW₁₋₂.

When describing the operation of the current direction control circuit 60, the current direction may be controlled by measuring the potential difference between the voltage equalization cell C_{E1} and the unit cell C₁ by the voltage comparator VC and controlling the switches SW₁₋₁ and SW₁₋₂ by the controller SWC.

Describing in more detail, the controller SWC performs a control so as not to turn-on the switches SW₁₋₁ and SW₁₋₂ when the voltage of the unit cell C₁ is lower than the voltage of the voltage equalization cell C_{E1} based on the potential difference between the voltage equalization cell C_{E1} and the unit cell C₁ measured by the voltage comparator VC during the operation of connecting the voltage equalization cell C_{E1} and the unit cell C₁ in parallel. On the other hand, the controller SWC may perform a control so as to turn-on the switches SW₁₋₁ and SW₁₋₂ when the voltage of the unit cell C₁ is higher than the voltage of the voltage equalization cell C_{E1}. By the method, current may be set to flow only in one direction between the voltage equalization cell C_{E1} and the unit cell C₁.

The current direction control circuit 60 may be used instead of the diode in the above-mentioned voltage equalization circuit.

Meanwhile, during the voltage equalization process of the voltage equalization circuit including the above-mentioned voltage equalization serial string, the voltage equalization cell serial string and the unit cell serial string performs the voltage equalization operation with respect to each other, such that the voltage equalization is also performed between the voltage equalization cells.

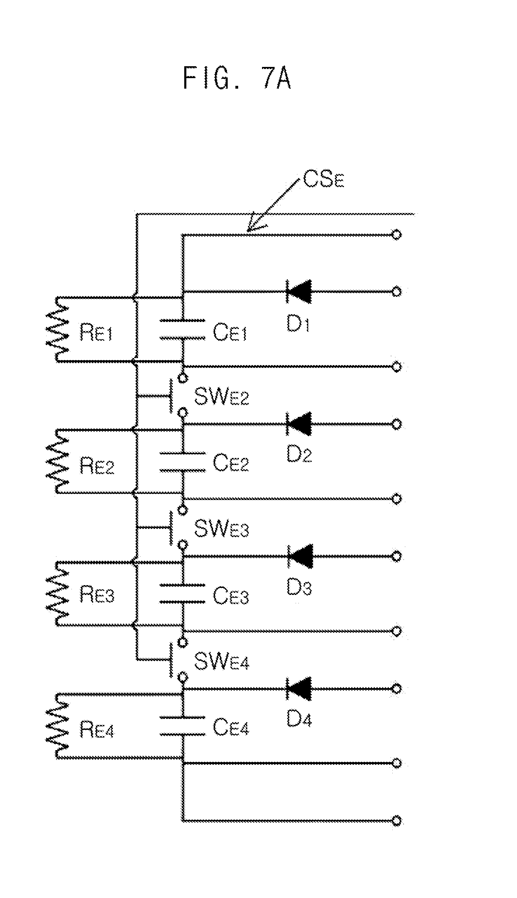

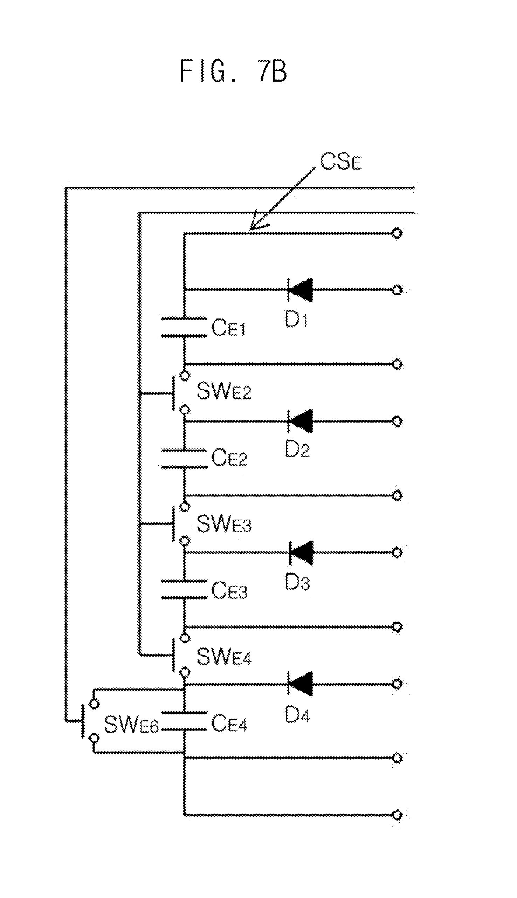

However, although there is very little probability, if the voltage of the unit cell in the unit cell series string is not uniform and the voltage of the voltage equalization cell connected with each unit cell in parallel is equal to the voltage of the unit cell, the voltage equalization process may be delayed. Therefore, the voltage equalization circuit capable of preventing the delay of the voltage equalization process will be described with reference to FIG. 7.

The circuit shown in FIG. 7A is a circuit in which resistors R_{E1}, R_{E2}, R_{E3}, and R_{E4} having a predetermined resistance value are each connected to the voltage equalization cells C_{E1}, C_{E2}, C_{E3}, and C_{E4} in parallel in the voltage equalization circuit 50 shown in FIG. 5.

The voltage equalization according to the circuit of FIG. 7A is one of the simplest methods among the voltage equalization methods but may generate the self discharge as the voltage equalization rate is increased. Generally, as the capacity of the cell is increased according to the capacity of the cells connected in parallel, the resistance value is small. Since the voltage equalization cell has the smaller capacity than the unit cell, the resistor having the larger resistance value may be used, such that the amount discharged by the unit cell of the unit cell serial string is not large by the resistors R_{E1}, R_{E2}, R_{E3}, and R_{E4} connected to the voltage equalization cells in parallel.

The circuit shown in FIG. 7B shows a circuit in which one voltage equalization cell C_{E4} of the voltage equalization cells C_{E1}, C_{E2}, C_{E3}, and C_{E4} connects to the switch SW_{E6} in parallel in the voltage equalization circuit 50 shown in FIG. 5.

The voltage equalization according to the circuit of FIG. 7B turns-on the switch SW_{E6} by the controller to discharge only one voltage equalization cell, such that the voltage of the unit cell serial string is equal to that of the voltage equalization serial string, thereby solving the delay conditions where the voltage equalization operation is not made.

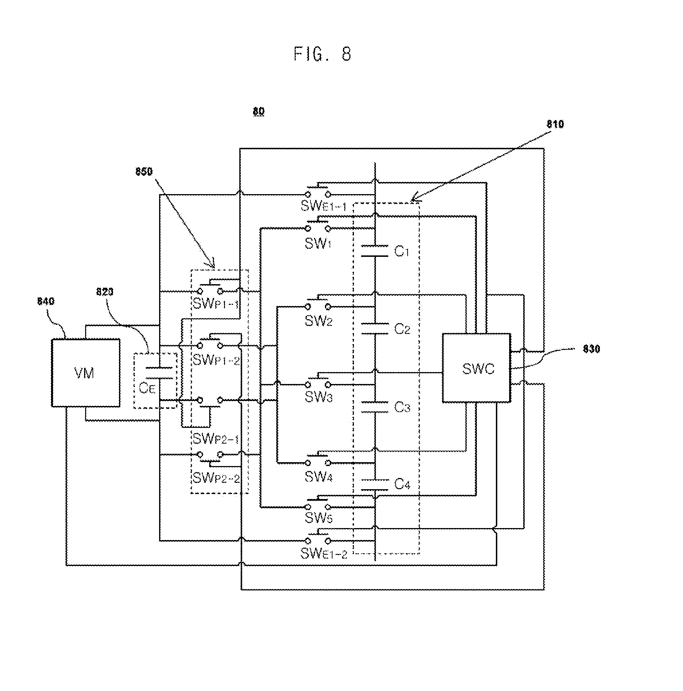

The voltage equalization rate of the voltage equalization circuit is affected by the number of voltage equalization cells, the capacity of voltage equalization cells, the parallel connection frequency per hour between the voltage equalization cells and the unit cell in the voltage equalization circuit, or the like, but the voltage equalization rate may be substantially increased by concentrating the voltage equalization to the unit cell requiring the voltage equalization. Hereinafter, the voltage equalization circuit increasing the voltage equalization rate by concentrating the voltage equalization to the unit cell requiring the voltage equalization will be described with reference to FIG. 8.

FIG. 8 shows a circuit diagram of the voltage equalization circuit that may increase the voltage equalization rate by differentiating the voltage equalization for each unit cell according to the exemplary embodiment of the present invention.

As shown in FIG. 8, a voltage equalization circuit 80 is configured to include a serial string CS 810 in which four electric double layer capacitor unit cells C₁, C₂, C₃, and C₄ are connected in series, a single voltage equalization cell C_{E} 820, switches SW₁ to SW₅ in which the voltage equalization cell 820 is connected to the unit cells C₁, C₂, C₃, and C₄ of the serial string in parallel, switches SW_{E1-1} and SW_{E1-2} in which the serial string 810 is connected with the voltage equalization cell 820 in parallel, switches SW_{P1-1}, SW_{P1-2}, SW_{P2-1}, and SW_{P2-2} of a polarity inversion circuit PIC 850 used for the parallel connection of the unit cell and the voltage equalization cell 820, a controller SWC 830 that controls the switches, and a unit cell voltage detector VM 840 that detects the voltage of each unit cell.

The voltage equalization circuit 80 shown in FIG. 8 is configured to further include the voltage detector 540 in the configuration of the voltage equalization circuit 10 shown in FIG. 1 and may drastically reduce the number of switches by using the polarity inversion circuit 850 when the number of serially connected unit cells of the serial string is increased.

The voltage equalization circuit 80 shown in FIG. 8 may perform the same voltage equalization operation as the voltage equalization circuit 10 shown in FIG. 1. Further, the voltage equalization circuit 80 may calculate the average voltage of each unit cell by using the added voltage detector 840 and detect the unit cell having the highest voltage and the lowest voltage among the unit cells. Therefore, the voltage equalization circuit 80 may perform the parallel connection on the necessary unit cells without performing the sequentially and repeatedly parallel connection during the process of performing the parallel connection between the voltage equalization cell 820 and the unit cells C₁, C₂, C₃, and C₄ or the parallel connection between the voltage equalization cell 820 and the serial string 810.

Describing in more detail, regarding the unit cell having higher voltage than the unit cell average voltage calculated by the voltage detector 840 during the parallel connection process, the voltage equalization circuit 80 may omit the parallel connection process between the voltage equalization cell 820 and the unit cell. Therefore, the voltage change amount of the unit cell may be increased and the parallel connection frequency per time between the voltage equalization cell 820 and each unit cell C₁, C₂, C₃, and C₄ may be increased and the voltage equalization rate may be increased.

In addition, the parallel connection between the unit cell having the lowest voltage and the voltage equalization cell 820 and the parallel between the voltage equalization cell 820 and the serial string 810 may be repeatedly and intensively performed.

In the case of the related art, in the conditions, the voltage equalization capacitor repeats the parallel connection operation between the unit cell having low voltage and the remaining three unit cells by receiving the electric energy from the remaining three unit cells, respectively, other than the unit cell having low voltage for the voltage equalization.

On the other hand, the exemplary embodiment of the present invention may perform the repeated parallel connection operation between the voltage equalization cell 820 and the unit cell having low voltage and the voltage equalization cell 820 and the serial string 810 in the same conditions, thereby increasing the voltage equalization rate of each unit cell according to the more intensive voltage equalization.

In addition, when the reverse voltage is applied to the serial string 810 during the voltage detection process, the voltage equalization circuit 80 senses it to turn-off the switches connecting the voltage equalization cell 820 and the serial string 810 in parallel to prevent the reverse voltage from being applied to the voltage equalization cell 820, which may configure the exemplary embodiment in order to generate the alarm signal to the electric energy storage device operating stop signal and notify it. That is, during the process of mounting the electric energy storage device, when polarity is changed (in particular, the secondary battery is distributed and installed in the charged state), it is possible to prevent accidents due to the application of reverse polarity (in particular, the case of using the aluminum electrolytic capacitor or the tantalum electrolytic capacitor, or the like, as the voltage equalization cell) and thus, it is very effective.

In addition, in the voltage equalization circuit 80 of FIG. 8, when the unit cell voltage of the serial string 810 is higher than a set upper value or lower than a set lower value, an additional function generating the alarm signal such as a logic signal may be added to the voltage detector 840 or the controller 830.

Meanwhile, when the ultracapacitor or the secondary battery such as the electric double layer capacitor as the unit cell in order to configure the serial string, it is possible to lower the unit cell capacity deviation at the time of the manufacturing but it may be inevitably cause the aging deviation due to the aging of the unit cell. That is, some degree of capacity deviations between the unit cells of the serial string according to the usage may be present. In this case, the charging and discharging behavior according to the voltage equalization method of the serial string may be changed.

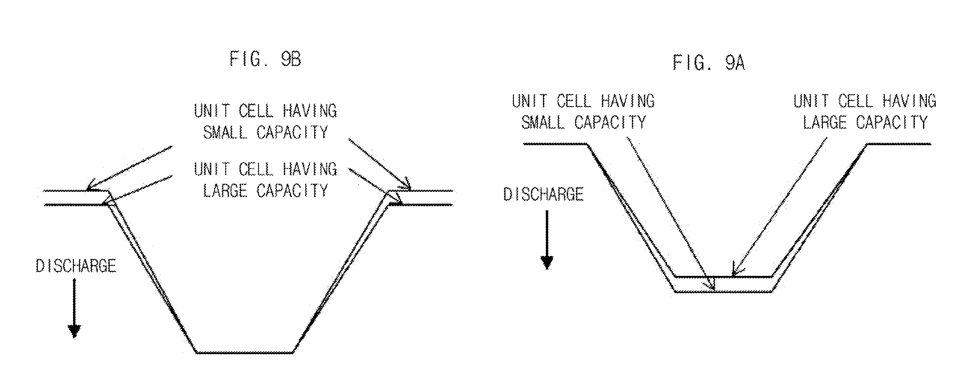

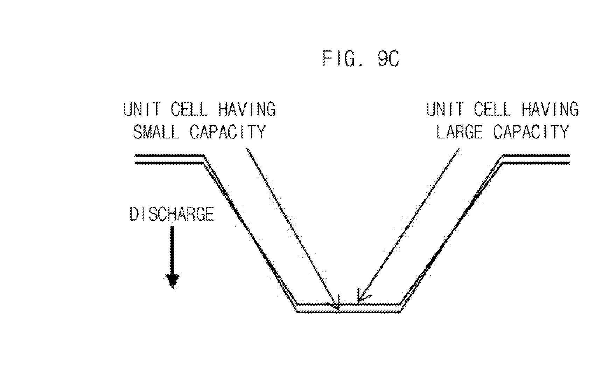

FIG. 9 shows a graph of a potential difference during the charging/discharging process of unit cells having different capacities that are connected in series.

FIG. 9A shows a case in which the voltage of the serial string is equalized at the charging voltage, FIG. 9B shows a case in which the voltage of the serial string is equalized at the discharging voltage, and FIG. 9C shows a case in which the voltage equalization operation of the serial string is made overall the voltage region.

As shown in FIG. 9A, when the voltage equalization operation of he serial string is made at the charging voltage, although the capacity deviations between the unit cells are present, the voltage of the unit cell of the serial string is constant at the charging voltage, but the discharging voltage of the unit cell is changed according to the capacity deviation of the unit cell when the serial string is discharged.

In addition, as shown in FIG. 9B, when the voltage equalization operation of the serial string is made at the discharging voltage, even though the capacity deviations between the unit cells are present, the discharging voltage of the unit cell is constant but the charging voltage is changed according to the capacity deviations.

As shown in FIG. 9C, when the voltage equalization operation of the serial string is made overall the voltage region, it can be appreciated that the voltage deviations may be dispersed as the charging voltage and the discharge voltagedue to the capacity deviations between the unit cells.

In the case of the electric double layer capacitor, the over-voltage exceeding the rated voltage has a fatal effect on the lifespan of the cell, but the low voltage does not have a large effect on the lifespan of the cell unless the excessively reverse voltage is applied. Therefore, enhancing the voltage equalization operation is more effective in the charging voltage region that is a region having the high voltage. To this end, when the voltage of the serial string is high, that is, when the parallel connection switching frequency is increased at the voltage equalization circuit and the voltage of the serial string is low as the applied voltage of the unit cells is high, the parallel connection switching frequency is reduced at the voltage equalization circuit to increase and reduce the parallel connection frequency per time to more effectively reduce and increase the voltage equalization rate for each voltage of the serial string.

In the above-mentioned description, although the voltage equalization circuit according to the method of transferring the electric energy to the voltage equalization cell as a medium is exemplified, the additional function considering the conditions in which the over-voltage is applied to the unit cell of the serial string is needed.

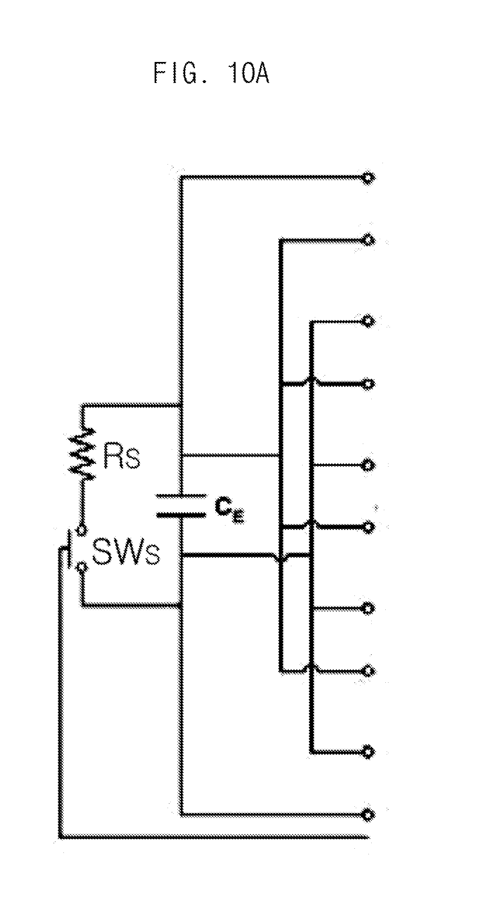

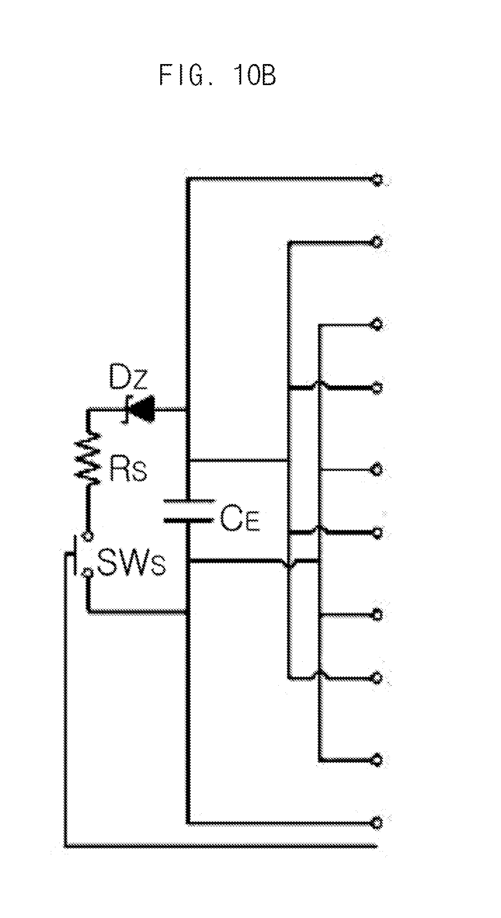

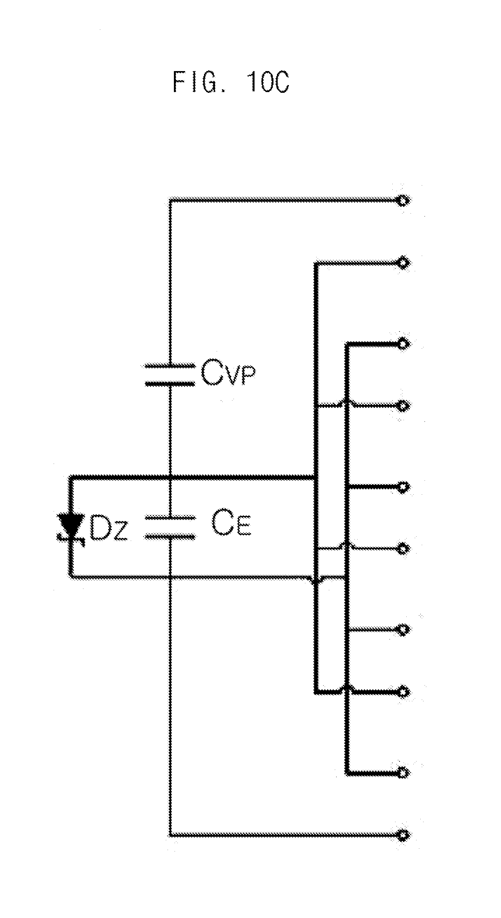

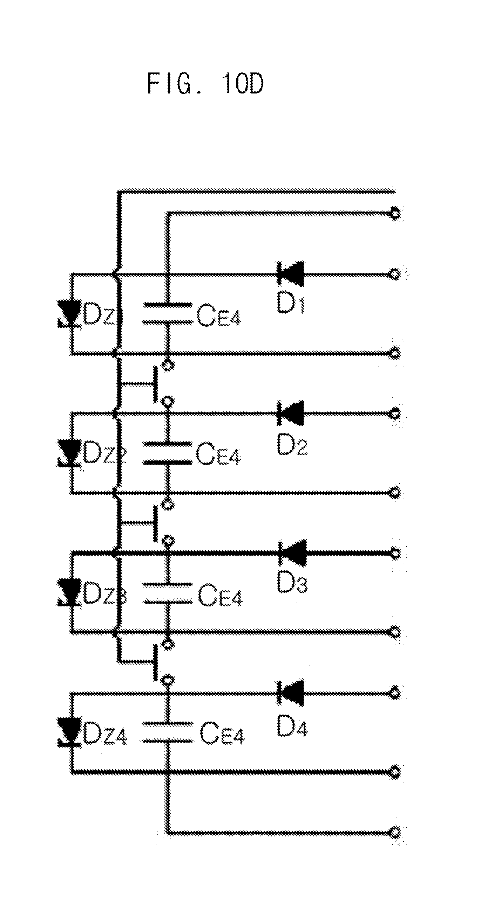

FIG. 10 is a circuit diagram of the voltage equalization circuit having the over-voltage preventing function according to the exemplary embodiment of the present invention.

In the voltage equalization circuit 10 shown in FIG. 1, the voltage equalization circuit shown in FIG. 10A connects the voltage equalization cell C_{E} 120 to the switches SW_{S} and serially connects the resistor R_{S} to the switch for limiting current. When the voltage equalization cell C_{E} is connected to the unit cell in parallel, the voltage of the unit cell exceeds the set value and thus, the switch SW_{S} is turned-on, such that the unit cell is operated to be discharged.

In the voltage equalization circuit 10 shown in FIG. 1, the voltage equalization circuit shown in FIG. 10B connects the voltage equalization cell C_{E} 120 to the switches SW_{S} in parallel and serially connects the resistor R_{S} to the zener diode D_{Z} for limiting current. When the voltage equalization cell CB is connected to the unit cell in parallel, the switch SW₈ is turned-on and the voltage of the unit cell exceeds the set breakdown voltage of the zener diode D_{Z} such that the unit cell is operated to perform the discharging due to the zener diode D_{Z}.

In the voltage equalization circuit 40 shown in IFG. 4, the voltage equalization circuit shown in FIG. 10C connects the zener diode D_{Z} to the voltage equalization cell C_{E} 421 in parallel. When the voltage equalization cell C_{E} is connected to the unit cell in parallel, the voltage of the unit cell exceeds the set breakdown voltage of the zener diode D_{Z} such that the unit cell is operated to perform the discharging due to the zener diode D_{Z}.

In the voltage equalization circuit 50 shown in FIG. 5, the voltage equalization circuit shown in FIG. 10D connects the zener diodes D_{Z1}, D_{Z2}, D_{Z3}, and D_{Z4} to the voltage equalization cells C_{E1}, C_{E2}, C_{E3}, and C_{E4} in parallel. When the voltage equalization cell is connected to the unit cell in parallel, the voltage of the unit cell exceeds the set breakdown voltage of the zener diode, such that the unit cell is operated to perform the discharging due to the zener diode.

In addition, the voltage equalization circuit shown in FIGS. 10A to 10D may use a switching element such as a shunt resistor to provide the flowing of current when exceeding the defined voltage such as the zener diode by substituting the zener diode.

Referring to FIGS. 1 to 10, in the voltage equalization circuit according to the exemplary embodiment of the present invention as described above, the voltage equalization cell may have the excellent durability and the relatively large capacitance. Therefore, according to the requirements, the electric double layer capacitor, the aluminum electrolytic capacitor, the tantalum electrolytic capacitor, or the like, may be used as the voltage equalization cell.

Although the description of the above-mentioned exemplary embodiment of the present invention describes the case in which the electric double layer capacitor as the electric energy storage cell, this is only for convenience of explanation and the exemplary embodiment of the present invention is not limited the object of the electric energy storage cell to the electric double layer capacity. In addition to the ultracapacitor such as the electric double layer capacitor according to the exemplary embodiment of the present invention, the case in which the electric energy storage cells such as the secondary battery or the electrolytic condenser are connected in series may be used. Further, although the exemplary embodiment of the present invention uses the case in which four unit cells are connected in series, the present invention does not specifically limit the serial number.

As described above, the exemplary embodiment of the present invention provides the voltage equalization method between the electric energy storage cells in the electric energy storage devices in which the electric energy storage cells are connected in series. An example of the electric energy storage cells may include an ultracapacitor such as an electric double layer capacitor, a lead acid battery, an NiMH battery, an NiCd battery, a lithium ion battery, an aluminum electrolytic capacitor, or the like.

A number of exemplary embodiments have been described above. Nevertheless, it will be understood that various modifications may be made. For example, suitable results may be achieved if the described techniques are performed in a different order and/or if components in a described system, architecture, device, or circuit are combined in a different manner and/or replaced or supplemented by other components or their equivalents. Accordingly, other implementations are within the scope of the following claims.

## Claims

1. A voltage equalization circuit, comprising:
an electric energy storage cell serial string in which a plurality of electric energy storage cells are connected in series;
at least one voltage equalization cell string that includes at least one voltage equalization cell;
a plurality of first switching units that connects the electric energy storage cell with the voltage equalization cell in parallel;
at least one second switching unit that connects the electric energy storage cell serial string with the voltage equalization cell string in parallel; and
a controller that controls the first switching unit and the second switching unit and performs a control so that the first switching unit and the second switching unit are not simultaneously in an ON state.

2. The voltage equalization circuit of claim 1, wherein the control performs a control so that the first switching unit and the second switching unit are alternately in an ON state.

3. The voltage equalization circuit of claim 1, wherein the voltage equalization cell string includes the plurality of voltage equalization cells so as to correspond to the plurality of electric energy storage cells, respectively.

4. The voltage equalization circuit of claim 3, further comprising a third switching unit that connects the plurality of voltage equalization cells in series, wherein the third switching unit is controlled by the controller.

5. The voltage equalization circuit of claim 4, wherein the third switching unit is in an ON state when the second switchig unit is in an ON state.

6. The voltage equalization circuit of claim 3, further comprising a current direction setting unit that is connected the electrice energy storage cell and the voltage equalization cell corresponding thereto in series.

7. The voltage equalization circuit of claim 6, wherein the current direction setting unit further includes a voltage detector that measures a potential difference between the electric energy storage cell and the voltage equalization cell.

8. The voltage equalization circuit of claim 3, wherein each of the plurality of voltage equalization cells are connected with a resistor in parallel.

9. The voltage equalization circuit of claim 1, further comprising a voltage detector that measures the voltage of the electric energy storage cell connected to the voltage equalization cell.

10. The voltage equalization circuit of claim 1, further comprising a discharge unit that is connected to the voltage equalization cell to discharge the electric energy storage cell when the voltage of the electric energy storage cell exceeds the predetermined value.

11. The voltage equalization circuit of claim 1, wherein the voltage equalization cell string includes at least one of voltage buffer cells connected with the voltage equalization cell in series.

12. The voltage equalization circuit of claim 11, wherein the voltage equalization cell string further includes a unit to prevent reverse polarity that is connected to the voltage buffer cell.

13. The voltage equalization circuit of claim 1, wherein the switching frequency of a first switching unit or a second switching unit is variable according to the voltage of the electric energy storage cell serial string.

14. The voltage equalization circuit of claim 1, wherein when the electric energy storage device and the voltage equalization circuit are divided into a plurality of modules, the divided voltage equalization circuits each include the controller.

15. The voltage equalization circuit of claim 14, wherein each controller of each of the divided voltage equalization circuits is operated by being synchronized.

16. The voltage equalization circuit of claim 14, wherein each controller of each of the divided voltage equalization circuits is operated by being asynchronized.

17. The voltage equalization circuit of claim 14, wherein each of the divided voltage equalization circuits includes a connection switch unit with the divided electric energy storage cells in order to provide the voltage equalization operation for the divided electric energy storage cell serial strings included in the module.

18. The voltage equalization circuit of claim 1, wherein the voltage equalization cell string includes at least one of an electric double layer capacitor, an aluminum electrolytic capacitor, and a tantalum electrolytic capacitor.
